# DEMANDE DE BREVET EUROPEEN

(11) **EP 3 650 577 A1**
(43) Date de publication de la demande: **13.05.2020**
(21) Numéro de dépôt: 19207213.0
(22) Date de dépôt: 05.11.2019
(51) Int. Cl.: C23C 14/24

(54) **DISPOSITIF D'ÉVAPORATION POUR SYSTÈME D'ÉVAPORATION SOUS VIDE, APPAREIL ET PROCÉDÉ DE DÉPÔT D'UN FILM DE MATIÈRE**

(30) Priorité: 06.11.2018 FR 1860207
(71) Demandeur: Riber, 95870 Bezons (FR)
(72) Inventeur: ROUSSEAU, Youri, 78600 Maisons Laffitte (FR); GUYAUX, Jean-Louis, 36600 La Vernelle (FR); STEMMELEN, Franck, 95490 VAUREAL (FR)
(74) Mandataire: Jacobacci Coralis Harle

(57) **Abrégé**

L'invention concerne un dispositif d'évaporation comprenant une cellule d'évaporation comportant des moyens de chauffage et un creuset ayant une extrémité ouverte en haut et un fond fermé en bas destiné à recevoir une charge, le dispositif étant adapté pour générer un flux de matière en phase vapeur par évaporation ou sublimation du matériau de la charge.

Selon l'invention, le dispositif d'évaporation comporte un insert filtrant comprenant une partie supérieure (20) ayant une ouverture conique (11) destinée à être disposée à l'extrémité ouverte du creuset, et une partie inférieure (21) comprenant du haut vers le bas une plaque (13) présentant au moins une ouverture (130) et une grille (14), la partie inférieure (21) étant destinée à être disposée dans le creuset entre la partie supérieure (20) et la charge.

Un appareil et un procédé de dépôt d'un film de matière sur un substrat sont également proposés.

## Description

### DOMAINE TECHNIQUE AUQUEL SE RAPPORTE L'INVENTION

La présente invention concerne de manière générale le domaine des équipements de dépôt de couche mince de matière sous vide.

Elle concerne plus particulièrement les procédés et les appareils pour déposer de la matière en phase vapeur sur un substrat.

Plus particulièrement, la présente invention s'applique au dépôt en couche mince de matériaux inorganiques et organiques.

### ARRIERE-PLAN TECHNOLOGIQUE

On connaît des documents antérieurs US 2007/074654 et US 5104695 des procédés et des appareils destinés au dépôt de matière en phase vapeur sur un substrat. En général, le dépôt de matière est réalisé dans une enceinte sous vide comprenant un moyen de chauffage, une pompe à vide et une cellule d'effusion, aussi appelée cellule d'évaporation, dans laquelle est disposé le matériau source à évaporer. Le matériau source à évaporer est chauffé à une température supérieure à environ 150°C et s'évapore à l'intérieur de la cellule d'effusion. En pratique, la cellule d'effusion possède au moins une ouverture permettant le passage du matériau en phase vapeur vers le substrat. Ainsi au contact du substrat, le dépôt de matière en phase vapeur se condense pour former une couche mince de matière solide. De cette façon il est possible de déposer une couche de matériau ou de superposer successivement plusieurs épaisseurs de couches minces de matière.

Les cellules d'effusion mises en jeu dans les procédés d'évaporation destinés à déposer un film de matière sur un substrat comprennent plusieurs éléments dont un creuset et un moyen de chauffage. Les moyens de chauffage sont généralement disposés autour du creuset. Le creuset présente en général une extrémité ouverte en haut et un fond fermé en bas dans lequel est déposé le matériau source. L'extrémité ouverte en haut du creuset permet le passage du matériau évaporé en phase vapeur vers le substrat. Bien souvent, un insert possédant une ouverture de taille prédéterminée est disposé sur l'extrémité ouverte en haut du creuset. L'insert a pour fonction principale de contrôler la dispersion du flux de matériau évaporé en sortie de cellule d'effusion. Cet insert permet aussi par exemple de limiter le passage de projections de matières solide et/ou liquide générées lors de l'évaporation du matériau source sur le substrat. Ces projections de matière engendrent des non-uniformités ou des défauts dans le(s) film(s) de matière déposée. L'insert permet aussi d'améliorer la reproductibilité de l'épaisseur d'un film lors de sa formation sur un substrat.

Cependant, la présence d'une ouverture sur l'insert entraîne une forte perte de chaleur au niveau de l'extrémité en haut du creuset qui génère un phénomène de condensation et donc un bouchage (appelé « clogging » en anglais) de l'ouverture de l'insert. Le bouchage de l'ouverture de l'insert peut rendre le flux de dépôt de matière instable lors du procédé de dépôt de matière sur un substrat. Ce phénomène de condensation de matière sur l'insert est d'autant plus accéléré que la température de vaporisation du matériau source est faible, c'est-à-dire pour une température inférieure ou égale à 600°C.

Dans le cas de dépôt de magnésium, par exemple pour la fabrication d'écran à base de diodes électroluminescentes organiques (OLED acronyme en anglais) de grandes dimensions, la température du creuset est relativement faible, de l'ordre de 400°C. La perte de chaleur à travers l'ouverture de l'insert refroidit l'insert et entraîne une condensation partielle du matériau en phase vapeur sur les parois de l'insert. Cette condensation sur l'insert modifie la dispersion du flux de matériau évaporé vers le substrat ce qui rend très difficile d'obtenir un dépôt d'épaisseur uniforme, reproductible et sans défaut.

Il est donc nécessaire de développer un dispositif et un procédé d'évaporation permettant d'éviter les problèmes de bouchage de l'ouverture de l'insert tout en réduisant les risques d'éclaboussures de matière solide et/ou liquide sur le substrat.

Un des buts de l'invention est de déposer en couche mince des matériaux organiques et inorganiques dont la tension de vapeur est comprise entre 10⁻³ mbar et 1 mbar à une température comprise entre 100°C et 600°C.

### OBJET DE L'INVENTION

Afin de remédier aux inconvénients précités de l'état de la technique, la présente invention propose un dispositif d'évaporation comprenant une cellule d'évaporation comportant des moyens de chauffage et un creuset ayant une extrémité ouverte en haut et un fond fermé en bas destiné à recevoir une charge de matériau à évaporer ou à sublimer, les moyens de chauffage étant adaptés pour chauffer le creuset contenant la charge et générer un flux de matière en phase vapeur par évaporation ou sublimation du matériau de la charge.

Selon l'invention, le dispositif d'évaporation comporte en outre un insert filtrant comprenant : une partie supérieure ayant une ouverture conique destinée à être disposée à l'extrémité ouverte du creuset, et une partie inférieure comprenant du haut vers le bas une plaque présentant au moins une ouverture et une grille, la partie inférieure étant destinée à être disposée dans le creuset entre la partie supérieure et la charge.

Le dispositif d'évaporation de la présente invention permet avantageusement d'améliorer l'uniformité et l'homogénéité du dépôt en couche mince sur un substrat et évite les projections de matière solide et/ou liquide provenant de l'évaporation ou de la sublimation de la charge vers le substrat.

Plus particulièrement, la partie inférieure de l'insert filtrant comprend du haut vers le bas une autre plaque présentant au moins une autre ouverture, la plaque présentant au moins une ouverture et la grille.

De façon particulièrement avantageuse, les moyens de chauffage comprennent une première zone de chauffage et une deuxième zone de chauffage, la première zone de chauffage étant disposée dans une partie basse de la cellule d'évaporation et la deuxième zone de chauffage étant disposée dans une partie haute de la cellule d'effusion.

De manière encore plus avantageuse, la plaque est disposée au dessus de la partie basse de la cellule d'évaporation, par exemple entre la première zone de chauffage et la deuxième zone de chauffage ou dans la deuxième zone de chauffage.

Selon l'invention, ladite au moins une ouverture de ladite plaque et ladite au moins une autre ouverture de ladite autre plaque sont disposées en chicane.

Avantageusement, la surface totale de ladite au moins une ouverture de ladite plaque est inférieure ou égale à 1% de la surface de ladite plaque.

Selon un autre mode de réalisation, la partie inférieure comprend du haut vers le bas ladite plaque, la grille et une autre grille, la grille présentant des pores de dimensions plus petites que les pores de la ladite autre grille.

Selon un mode de réalisation, l'ouverture conique de l'insert filtrant forme un cône de révolution ayant un sommet tronqué et une base.

De façon avantageuse, l'insert filtrant comprend un couvercle ayant une ouverture disposée autour de l'ouverture conique de l'insert filtrant, ledit couvercle étant adapté pour isoler thermiquement le creuset.

Le dispositif d'évaporation peut comporter en outre des moyens de fixation entre la partie inférieure et la partie supérieure de l'insert filtrant.

L'invention propose également un appareil de dépôt d'un film de matière sur un substrat comprenant le dispositif d'évaporation de la présente invention et une enceinte de dépôt sous vide, ledit appareil de dépôt étant adapté pour déposer au moins un film de ladite matière en phase vapeur sur un substrat.

L'invention propose également un procédé de dépôt d'un film de matière sur un substrat comprenant les étapes suivantes :
- positionnement d'une charge de matériau à évaporer ou à sublimer dans le fond du creuset d'un appareil de dépôt de la présente invention,
- mise sous vide par pompage de l'enceinte,
- chauffage du creuset contenant la charge de manière à générer un flux de matière en phase vapeur par évaporation ou sublimation de la charge,
- filtrage par l'insert filtrant de matière solide et/ou liquide tout en laissant passer le flux de matière en phase vapeur à travers l'ouverture conique, et
- dépôt du film de ladite matière en phase vapeur sur le substrat.

### DESCRIPTION DETAILLEE D'UN EXEMPLE DE RÉALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 représente schématiquement un appareil de dépôt de matière sous vide selon l'art antérieur,
- la figure 2 est une vue éclatée d'une cellule d'effusion selon l'art antérieur,
- la figure 3 est une vue en perspective d'un insert filtrant selon un exemple de réalisation de la présente invention,
- la figure 4 est vue de face d'un exemple d'une plaque présentant trois ouvertures de forme circulaire,
- la figure 5 est une vue en coupe transversale d'un insert filtrant selon un exemple de réalisation de la présente invention,
- la figure 6 est une vue en coupe transversale d'un insert filtrant selon un autre exemple de réalisation de la présente invention.

### Dispositif et Procédé

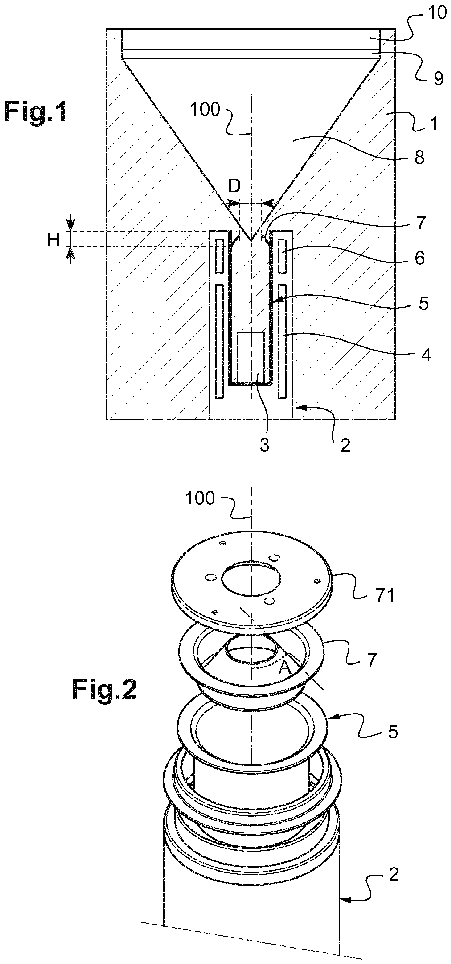

Sur la figure 1, on a représenté une vue en coupe d'un exemple d'appareil de dépôt de matière sous vide issu de l'art antérieur. L'appareil comprend une enceinte sous vide 1 dans laquelle est placée une cellule d'effusion 2, aussi appelée cellule d'évaporation, et un substrat 10. L'enceinte est maintenue sous vide grâce à une pompe à vide par exemple. Le substrat 10 est positionné à une distance prédéterminée de la cellule d'effusion 2 de manière à contrôler la formation du dépôt d'une couche mince 9 de matière sur le substrat 10. Les dimensions du substrat 10 peuvent varier sur une gamme de 10 mm x 10 mm à 2000 mm x 2000 mm. L'épaisseur de couche mince déposée est généralement comprise entre 0,1 nm et 1000 nm. La cellule d'effusion 2 comprend un creuset 5 et des moyens de chauffage 4 et 6. Le creuset 5 comprend en haut une extrémité ouverte et en bas un fond fermé. Le matériau source, aussi appelé charge, est déposé dans le fond fermé en bas du creuset 5. La charge 3 est généralement déposée dans le creuset 5 sous forme solide. Après chauffage, selon le matériau et la température de chauffage, la charge reste solide ou est transformée en liquide. Une charge solide est destinée à être sublimée en phase vapeur et une charge liquide est destinée à être évaporée en phase vapeur. Généralement, la hauteur initiale de la charge correspond au tiers de la hauteur du creuset 5. La charge est par exemple choisie parmi les matériaux ayant une température d'évaporation comprise entre 150°C et 1500°C ou une température de sublimation comprise entre 150°C et 1500°C.

Dans cet exemple, les moyens de chauffage sont divisés en deux parties : une première zone de chauffage 4 et une deuxième zone de chauffage 6. La première zone de chauffage 4 est disposée dans la partie basse de la cellule d'effusion 2, qui s'étend par exemple du fond jusqu'aux deux tiers de la hauteur de la cellule d'effusion 2. La deuxième zone de chauffage 6 est disposée dans la partie haute de la cellule d'effusion 2 par exemple s'étendant entre l'extrémité ouverte du creuset 5 jusqu'au tiers de la hauteur de la cellule d'effusion 2.

Les moyens de chauffage peuvent par exemple comprendre une pluralité de résistances de chauffage. Généralement, les moyens de chauffage sont disposés autour de la partie extérieure du creuset 5. Le creuset 5 est par exemple amovible. Sur la figure 1, les moyens de chauffage sont disposés autour des parois latérales du creuset. Les gammes de température de chauffage du creuset sont comprises entre 150°C et 1500°C selon le matériau de la charge utilisée.

Un insert 7 est disposé sur l'extrémité ouverte en haut du creuset 5. L'insert 7 est par exemple un insert formant un couvercle en tôle comprenant une ouverture conique pour contrôler le flux de matière 8 à déposer sur le substrat 10.

La figure 2 est une vue éclatée de la cellule d'effusion décrite en lien avec la figure 1. Le creuset 5 est par exemple fabriqué dans un matériau choisi parmi le nitrure de bore pyrolytique ou le tantale.

Dans ce mode de réalisation le creuset 5 est de forme cylindrique de section circulaire, fermé à une extrémité et ouvert à l'autre extrémité. La géométrie et la forme du creuset 5 sont des paramètres non limitatifs.

L'insert 7 comprend une ouverture conique, par exemple de section circulaire. L'ouverture conique est définie par des paramètres géométriques tels qu'un angle d'ouverture A par rapport à l'axe 100 du cylindre, une hauteur H et un diamètre D d'ouverture. L'insert 7 peut par exemple être fabriqué dans un matériau choisi parmi le tantale ou le nitrure de bore. La forme conique de l'insert 7 permet de contrôler le flux de matière en phase vapeur et ainsi de contrôler l'uniformité du dépôt de matière sur le substrat. L'insert 7 est adapté pour se fixer sur l'extrémité ouverte du creuset.

De façon avantageuse, on superpose sur l'insert 7 un couvercle 71 possédant une ouverture d'un diamètre supérieur de quelques millimètres (par exemple entre 2 mm et 3 mm) à celui de l'ouverture de l'insert. Le couvercle permet de conserver la chaleur dans la cellule ce qui permet de limiter le rayonnement thermique de la cellule d'effusion. Le couvercle 71 est par exemple disposé sur le dessus de la cellule d'effusion.

Toutefois, dans le cas d'évaporation de magnésium pour la fabrication d'écrans à base de diodes électroluminescentes organiques de grandes dimensions, l'évaporation du magnésium s'effectue dans une gamme de température relativement basse comprise environ entre 400°C et 500°C. Une constatation faisant partie de la présente divulgation est que cette évaporation à basse température peut entraîner un phénomène de condensation du magnésium sur les parois de l'insert 7. Ce phénomène de condensation du magnésium modifie le flux sortant de la cellule d'effusion et à terme vient boucher l'ouverture de l'insert. Par ailleurs, l'évaporation du magnésium engendre la formation d'un dépôt de cendres indésirables sur le substrat, rendant ainsi le procédé de fabrication des écrans à base de diodes électroluminescentes organiques de grandes dimensions peu robuste et très aléatoire.

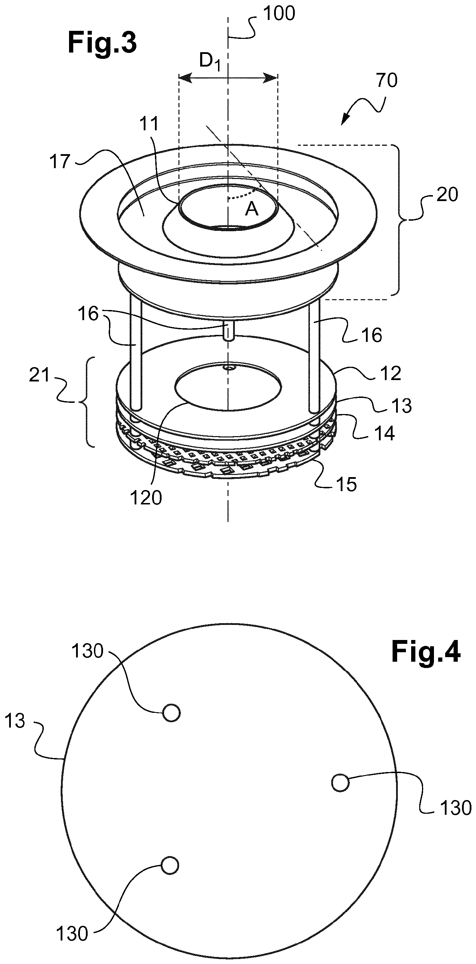

La figure 3 représente schématiquement une vue en perspective d'un insert filtrant 70 selon un exemple de réalisation de la présente divulgation. Le dispositif d'évaporation comprend au moins un moyen de chauffage, un creuset 5 similaire à celui décrit précédemment sur les figures 1 et 2 et un insert filtrant 70. Le moyen de chauffage présente au moins une zone de chauffage située autour ou dans les parois du creuset. Le moyen de chauffage comprend par exemple une pluralité de résistances électriques.

L'insert filtrant 70 comprend une partie supérieure 20 dotée d'une ouverture conique 11 de diamètre D1 destinée à être disposée à l'extrémité ouverte du creuset et une partie inférieure 21 comprenant au moins une plaque et au moins une grille.

Dans l'exemple représenté figure 3, la partie inférieure 21 de l'insert filtrant 70 comprend du haut vers le bas deux plaques et deux grilles. Les deux plaques comprennent du bas vers le haut une plaque 13 présentant au moins une ouverture 130 et une autre plaque 12 présentant au moins une autre ouverture 120. Les deux grilles comprennent du haut vers le bas une grille 14 et une autre grille 15. La partie inférieure 21 est destinée à être disposée dans le creuset entre la partie supérieure 20 et la charge 3 dans le fond du creuset.

Ladite au moins une autre ouverture 120 de ladite autre plaque 12 (illustrée sur la figure 3) et ladite au moins une ouverture 130 de ladite plaque 13 (illustrée figure 4) sont disposées en chicane de manière à empêcher le passage de matière solide et/ou liquide entre l'intérieur et l'extérieur du creuset à travers l'ouverture conique, notamment lors d'une évaporation ou d'une vaporisation de la charge.

Dans l'exemple représenté, le creuset ayant une section circulaire, ladite autre plaque 12 a une forme de rondelle trouée au centre et la plaque 13 a une forme de disque percé de plusieurs ouvertures. Toutefois, ces formes ne sont nullement limitatives.

La figure 4 représente un exemple de la plaque 13 avec ses ouvertures 130. Ici, la plaque 13 présente par exemple trois ouvertures 130 de forme circulaire disposées hors d'axe. Le diamètre des ouvertures 130 de forme circulaire de la plaque 13 est compris entre 0,5 mm et 10 mm. Le nombre et la géométrie de l'ouverture 130 étant non limitatifs.

La grille 14 présente des pores de dimensions plus petites que les pores de ladite autre grille 15 de sorte à filtrer la matière solide et/ou liquide générée lors de l'évaporation ou de la vaporisation de la charge.

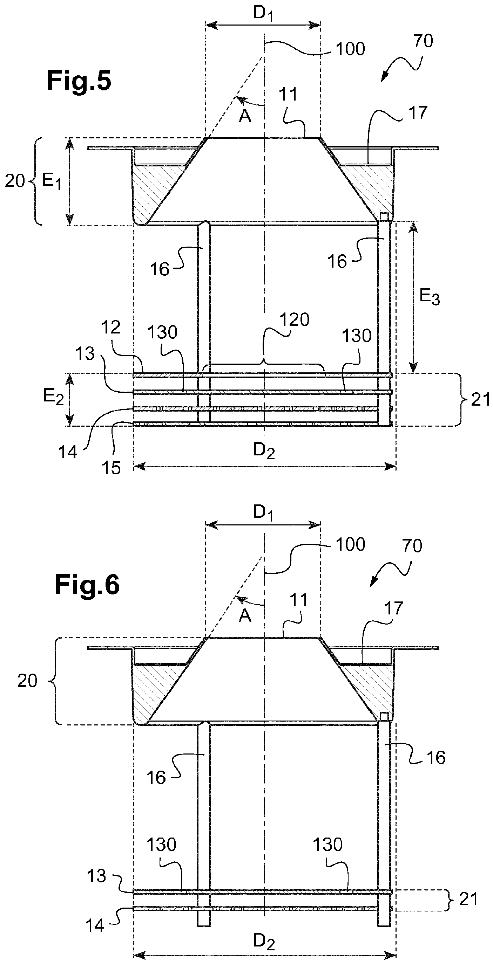

Dans le mode de réalisation illustré sur la figure 5, la partie supérieure 20 de l'insert filtrant 70 possède une forme extérieure cylindrique et une ouverture conique 11 de diamètre intérieur D1. Le diamètre intérieur D1 de l'ouverture conique 11 est compris entre 2 mm et 100 mm. De préférence, le diamètre intérieur D1 de l'ouverture conique 11 est inférieur ou égal à la moitié du diamètre interne du creuset. La partie supérieure 20 de l'insert filtrant possède une hauteur E1 comprise entre 5 mm et 80 mm. Sur la figure 5, la hauteur E1 correspond à la distance séparant le sommet de l'ouverture conique 11 de diamètre D1 et la base de l'ouverture conique 11.

La partie supérieure 20 de l'insert filtrant possède un diamètre extérieur D2 légèrement inférieur à celui du diamètre interne du creuset pour permettre l'insertion et/ou l'extraction de l'insert filtrant après avoir placé la charge dans le creuset.

La partie inférieure 21 de l'insert filtrant possède une hauteur E2 comprise entre 3 mm et 40 mm, de préférence entre 8 mm et 25 mm. Sur la figure 5, la hauteur E2 correspond à la distance qui sépare la face de ladite autre plaque 12 tournée en direction de l'ouverture du creuset et la face de ladite autre grille 15 orientée vers le fond du creuset.

La partie supérieure 20 et la partie inférieure 21 de l'insert filtrant peuvent être amovibles et indépendantes. La partie supérieure 20 et la partie inférieure 21 de l'insert filtrant sont par exemple reliées entre elles grâce à un système de fixation comprenant une pluralité de tiges ou de colonnettes 16, comme illustré sur la figure 3. En variante, la partie supérieure 20 et la partie inférieure 21 peuvent être reliées entre elles par un tube éventuellement percé par une pluralité de trous pour réduire le phénomène d'écrantage thermique. Une autre variante consiste à fixer la partie inférieure 21 de l'insert filtrant sur un rebord interne du creuset et séparément la partie supérieure 20 sur l'extrémité ouverte du creuset. La hauteur E3 correspondant à la distance séparant la partie supérieure 20 de la partie inférieure 21 de l'insert filtrant est comprise entre 20 mm et 80 mm. De préférence, la hauteur E3 est définie de sorte à disposer la plaque 13 entre les deux zones de chauffage. Selon une variante, la plaque 13 est disposée dans la partie haute de la cellule d'effusion 2, autrement dit au niveau de la deuxième zone de chauffage 6. Dans cette variante, la plaque 13 est aussi disposée au dessus de la partie basse de la cellule d'effusion entourée par la première zone de chauffage 4. Dans tous les cas, l'insert 70 se situe au dessus de la partie basse de la cellule d'effusion entourée par la première zone de chauffage 4. Cette disposition de l'insert 70 - et notamment de la plaque 13 entre les deux zones de chauffage ou dans la deuxième zone de chauffage 6, et toujours au dessus de la partie basse de la cellule d'effusion 2- permet de découpler thermiquement la partie haute de la partie basse de la cellule d'effusion 2.

L'ouverture conique 11 de l'insert filtrant forme par exemple un cône de révolution autour de l'axe 100, le cône ayant un sommet tronqué. Le sommet tronqué définit l'ouverture conique de l'insert filtrant. Par exemple, l'ouverture conique de l'insert filtrant possède un angle d'ouverture A par rapport à l'axe 100 du creuset compris entre 0 degré et 60 degrés, une hauteur E1 définie entre le sommet et la base de l'ouverture conique 11 comprise entre 5 mm et 80 mm, et un diamètre D1 d'ouverture compris entre 2 mm et 100 mm. De préférence, le diamètre intérieur D1 de l'ouverture conique 11 est inférieur ou égal à la moitié du diamètre interne du creuset. Avantageusement, la hauteur E1 est supérieure au tiers de la hauteur de la deuxième zone de chauffage 6 de la cellule d'effusion 2. Le sommet tronqué de l'ouverture conique 11 peut être orienté vers le substrat 10 ou à l'opposé vers le fond du creuset.

Le matériau de l'ouverture conique peut être choisi parmi le tantale, le molybdène, l'acier inoxydable, le titane, le niobium, le tungstène, ou le graphite. Selon le matériau, l'ouverture conique peut être réalisée par emboutissage ou par usinage. De façon alternative, l'ouverture conique peut être réalisée par croissance de nitrure de bore pyrolytique sur un support tel qu'un mandrin.

La forme de l'ouverture conique 11 de l'insert filtrant est non limitative et varie en fonction de chaque application.

En option, l'insert filtrant représenté sur la figure 3 présente une gorge 17 située autour de l'ouverture conique 11. La gorge 17 en forme de disque permet par exemple de déposer un couvercle avec une ouverture disposée de manière à être alignée avec l'ouverture conique de l'insert filtrant. Ledit couvercle est adapté pour isoler thermiquement le creuset et ainsi limiter le rayonnement thermique du substrat. Le couvercle permet également de conserver au maximum la chaleur dans la cellule d'effusion et limite le phénomène de condensation sur l'insert filtrant. Le couvercle est fabriqué dans un matériau choisi parmi le tantale, le molybdène ou l'acier inoxydable.

Le matériau des plaques 12 et 13 et des grilles 14 et 15 est choisi parmi les matériaux suivants : acier inoxydable, tantale, molybdène, titane, nickel, niobium, tungstène, graphite, graphite pyrolytique, nitrure de bore pyrolytique, alumine ou les matériaux céramiques.

Dans certaines applications, le matériau des éléments de la partie supérieure 20 et de la partie inférieure 21 de l'insert filtrant est en acier inoxydable. Cependant, le choix du matériau des éléments de la partie supérieure 20 ou des colonnettes 16 dépend de chaque application.

Le matériau des colonnettes 16 est choisi parmi les matériaux suivants : tantale, molybdène, acier inoxydable, titane, niobium, ou tungstène.

Le matériau de la charge à utiliser est choisi parmi les matériaux suivants : argent, arsenic, baryum, béryllium, bismuth, calcium, cadmium, césium, cuivre, dysprosium, erbium, europium, gallium, mercure, indium, potassium, lutécium, magnésium, sodium, néodyme, phosphore, plomb, rubidium, soufre, antimoine, sélénium, samarium, étain, strontium, tellure, thallium, ytterbium, zinc, halogénure métallique, chalcogénure métallique, oxyde ou les matériaux organiques.

Le dispositif d'évaporation muni de l'insert filtrant 70 est adapté pour évaporer ou sublimer par exemple des matériaux à forte pression de vapeur dans une gamme de température relativement faible comprise entre 150°C et 500°C tel que le magnésium.

Ladite autre plaque 12 présente au moins une autre ouverture 120 par exemple de forme circulaire et centrée sur l'axe 100, comme illustré sur les figures 3 ou 5. Le diamètre maximal de l'ouverture circulaire 120 est inférieur ou égal au diamètre intérieur tangent aux ouvertures de la plaque 13. Les ouvertures respectives de ladite autre plaque 12 et de la plaque 13 sont disposées en chicane de sorte à bloquer le passage de matière solide et/ou liquide lors du processus d'évaporation ou de sublimation de la charge. Autrement dit, en projection dans un plan transverse à l'axe 100, la ou les autres ouvertures 120 de ladite autre plaque 12 sont décalées et sans intersection par rapport à la ou les ouvertures 130 de la plaque 13.

L'espacement entre chaque élément de la partie inférieure 21 de l'insert filtrant est compris entre environ 1 mm et 5 mm, de préférence entre 2 mm et 3 mm. Avantageusement, l'espacement entre chaque élément de la partie inférieure 21 de l'insert filtrant permet de faciliter le nettoyage entre la grille 14 et ladite autre grille 15, par exemple par nettoyage chimique. En variante, le nettoyage des grilles 14 et 15 peut être réalisé par chauffage à haute température.

La taille des pores de la grille 14 est comprise entre 0,1 mm et 1 mm. La taille des pores de ladite autre grille 15 est comprise entre 0,5 mm et 5 mm. Ladite autre grille 15 est adaptée pour filtrer les projections de matières solide et/ou liquide de grande taille de l'ordre du mm. La grille 14 est adaptée pour empêcher le passage des projections de matière solide et/ou liquide de petite taille (inférieure au mm) qui n'ont pas pu être filtrées par ladite autre grille 15.

L'insert filtrant 70 est adapté pour être inséré en fonction de la géométrie du creuset. Les éléments de l'insert filtrant 70 peuvent être amovibles ou solidaires les uns des autres.

L'insert filtrant peut être démontable et conçu en deux blocs distincts comme par exemple un bloc comprenant la partie supérieure 20 et un autre bloc comprenant la partie inférieure 21. En variante, l'insert filtrant est non démontable et est conçu en un seul bloc. Toutefois, l'insert filtrant est conçu pour pouvoir être extrait du creuset notamment pour changer la charge dans le creuset.

L'insert filtrant a l'avantage d'être compatible avec d'anciennes cellules d'évaporation. L'insert filtrant peut ainsi être monté sur d'anciennes cellules d'évaporation par exemple à la place d'un insert classique.

L'insert filtrant évite le passage de projections de matière solide et/ou liquide générées lors de l'évaporation ou de la sublimation du matériau source à travers l'ouverture conique en direction du substrat. De plus, l'insert filtrant évite la condensation de matière sur l'ouverture conique de l'insert. Inversement, l'insert filtrant évite de polluer la charge disposée au fond du creuset par des poussières provenant par exemple de l'enceinte de dépôt et/ou du substrat.

Ladite autre grille 15, la grille 14, la plaque 13 et ladite autre plaque 12 laissent passer le flux de matière en phase gazeuse successivement à travers les pores des grilles 15 et 14 puis à travers les ouvertures des plaques 13 et 12. Le flux de matière en phase gazeuse est compensé en augmentant la température de la cellule d'effusion.

Ainsi, seul le flux de matière en phase gazeuse passe à travers l'ouverture conique 11 en direction du substrat 10.

L'insert filtrant permet de filtrer sélectivement le flux de gaz tout en évitant toute projection de matière solide et/ou liquide du creuset vers l'enceinte à vide. L'insert filtrant protège la charge disposée dans le creuset de toute pollution par des poussières ou particules indésirables.

En fonction de l'application souhaitée et de la taille des projections de matières solide et/ou liquide générées lors de l'évaporation du matériau source sur le substrat, la partie inférieure 21 de l'insert filtrant 70 peut présenter différentes configurations alternatives et comprendre du haut vers le bas :
- la plaque 13 présentant au moins une ouverture 130 et la grille 14,
- ou ladite autre plaque 12 présentant au moins une autre ouverture 120, la plaque 13 présentant au moins une ouverture 130 et la grille 14,
- ou la plaque 13 présentant au moins une ouverture 130, la grille 14 et ladite autre grille 15.

Dans le cas où les projections de matière solide et/ou liquide générées lors de l'évaporation du matériau source sont en faible quantité, la partie inférieure 21 de l'insert filtrant 70 peut comprendre la plaque 13 présentant au moins une ouverture 130, ladite autre plaque 12 présentant au moins une autre ouverture 120 et la grille 14.

De préférence, la partie inférieure 21 de l'insert filtrant 70 peut comprendre la plaque 13 présentant une pluralité d'ouvertures et les deux grilles 14 et 15. Dans cette configuration, la surface totale des ouvertures 130 de la plaque 13 représente par exemple 1% de la surface totale de la plaque 13, ce qui permet de découpler thermiquement la partie haute et la partie basse de la cellule d'effusion 2. La grille 14 présente par exemple des pores de dimensions plus petites que les pores de la ladite autre grille 15. La combinaison d'au moins une plaque et d'au moins une grille permet d'empêcher le passage de matière solide et/ou liquide tout en laissant passer ledit flux de matière en phase vapeur à travers l'ouverture conique 11.

En variante la partie inférieure 21 de l'insert filtrant 70 peut comprendre la plaque 13 présentant au moins une ouverture 130 et la grille 14 comme l'illustre la figure 6.

Un appareil de dépôt de matière selon la présente divulgation comprend une enceinte de dépôt sous vide et le dispositif d'évaporation de la présente invention. L'enceinte de dépôt est dotée d'une pompe à vide qui permet de maintenir l'intérieur de l'enceinte sous vide. L'enceinte de dépôt comprend aussi un support pour disposer le substrat 10 en face du dispositif d'évaporation et de préférence des capteurs pour mesurer l'épaisseur de la couche de dépôt formée sur le substrat.

Le procédé de dépôt d'un film de matière sur un substrat comprend les étapes suivantes :
- positionnement d'une charge 3 de matériau à évaporer ou à sublimer dans le fond du creuset d'un appareil de dépôt selon la présente invention,
- mise sous vide par pompage de l'enceinte 1,
- chauffage du creuset contenant la charge 3 de manière à générer un flux de matière en phase vapeur par évaporation ou sublimation de la charge 3,
- filtrage par l'insert filtrant 70 de matière solide et/ou liquide tout en laissant passer le flux de matière en phase vapeur à travers l'ouverture conique 11, et
- dépôt du film de ladite matière en phase vapeur sur le substrat 10.

Le chauffage du creuset transforme la charge solide et/ou liquide en flux de gaz qui passe successivement au travers de ladite autre grille 15, la grille 14, au moins une ouverture 130 de la plaque 13, au moins une autre ouverture 120 de ladite autre plaque 12 et l'ouverture conique 11 de l'insert filtrant 70 jusqu'à atteindre le substrat 10.

L'insert filtrant 70 bloque le passage de matière solide et/ou liquide entre l'intérieur et l'extérieur de la cellule d'effusion 2 et notamment à travers l'ouverture conique, la matière solide et/ou liquide étant générée en particulier lors de l'évaporation ou la sublimation de la charge. Le filtrage sélectif est effectué au moyen de l'insert filtrant, successivement par ladite autre grille 15, la grille 14, la plaque 13 et ladite autre plaque 12, pour ne laisser passer que le flux de matière en phase gazeuse à travers l'ouverture conique 11 qui contrôle la distribution spatiale et temporelle du flux de matière en phase gazeuse déposé sur le substrat 10.

La combinaison et la disposition en série des éléments de l'insert filtrant 70 permettent d'améliorer l'uniformité et l'homogénéité du dépôt en couche mince sur le substrat 10. L'insert filtrant 70 évite les projections de matière solide et/ou liquide provenant de l'évaporation ou de la sublimation de la charge vers le substrat et les parois de la chambre de dépôt sous vide. De plus, l'insert filtrant 70 évite la contamination de la charge par des poussières provenant de la chambre de dépôt sous vide ou du substrat. L'insert filtrant de la présente divulgation permet d'obtenir un dépôt de matière d'épaisseur et de composition uniforme sur toute la surface du substrat, y compris à une température inférieure à 1000°C et de préférence inférieure ou égale à 600°C.

## Revendications

1. Dispositif d'évaporation comprenant une cellule d'évaporation (2) comportant des moyens de chauffage (4, 6) et un creuset (5) ayant une extrémité ouverte en haut et un fond fermé en bas destiné à recevoir une charge (3) de matériau à évaporer ou à sublimer, les moyens de chauffage (4, 6) étant adaptés pour chauffer le creuset contenant la charge et générer un flux de matière en phase vapeur par évaporation ou sublimation du matériau de la charge (3), **caractérisé en ce que** le dispositif d'évaporation comporte en outre un insert filtrant (70) comprenant :
- une partie supérieure (20) ayant une ouverture conique (11) destinée à être disposée à l'extrémité ouverte du creuset (5),
- et une partie inférieure (21) comprenant du haut vers le bas une plaque (13) présentant au moins une ouverture (130) et une grille (14), la partie inférieure (21) étant destinée à être disposée dans le creuset (5) entre la partie supérieure (20) et la charge (3).

2. Dispositif d'évaporation selon la revendication 1, dans lequel les moyens de chauffage comprennent une première zone de chauffage (4) et une deuxième zone de chauffage (6), la première zone de chauffage (4) étant disposée dans une partie basse de la cellule d'évaporation (2), la deuxième zone de chauffage (6) étant disposée dans une partie haute de la cellule d'évaporation (2).

3. Dispositif d'évaporation selon la revendication 2, dans lequel la plaque (13) est disposée au dessus de la partie basse de la cellule d'évaporation (2).

4. Dispositif d'évaporation selon l'une des revendications 1 à 3, dans lequel la partie inférieure (21) comprend du haut vers le bas une autre plaque (12) présentant au moins une autre ouverture (120), la plaque (13) présentant au moins une ouverture (130) et la grille (14).

5. Dispositif d'évaporation selon la revendication 4, dans lequel ladite au moins une ouverture (130) de ladite plaque (13) et ladite au moins une autre ouverture (120) de ladite autre plaque (12) sont disposées en chicane.

6. Dispositif d'évaporation selon l'une des revendications 1 à 5, dans lequel la surface totale de ladite au moins une ouverture (130) de ladite plaque (13) est inférieure ou égale à 1% de la surface de ladite plaque (13).

7. Dispositif d'évaporation selon l'une des revendications 1 à 6, dans lequel la partie inférieure (21) comprend du haut vers le bas ladite plaque (13), la grille (14) et une autre grille (15), la grille (14) présentant des pores de dimensions plus petites que les pores de la ladite autre grille (15).

8. Dispositif d'évaporation selon l'une des revendications 1 à 7, dans lequel l'ouverture conique (11) de l'insert filtrant (70) forme un cône de révolution ayant un sommet tronqué et une base.

9. Dispositif d'évaporation selon l'une des revendications 1 à 8, dans lequel l'insert filtrant (70) comprend un couvercle ayant une ouverture disposée autour de l'ouverture conique (11) de l'insert filtrant (70), ledit couvercle étant adapté pour isoler thermiquement le creuset (5).

10. Dispositif d'évaporation selon l'une des revendications 1 à 9, comportant en outre des moyens de fixation (16) entre la partie inférieure (21) et la partie supérieure (20) de l'insert filtrant (70).

11. Appareil de dépôt d'un film de matière sur un substrat (10) comprenant un dispositif d'évaporation selon l'une des revendications 1 à 10 et une enceinte (1) de dépôt sous vide, ledit appareil de dépôt étant adapté pour déposer au moins un film de ladite matière en phase vapeur sur un substrat (10).

12. Procédé de dépôt d'un film de matière sur un substrat (10) comprenant les étapes suivantes :
- positionnement d'une charge (3) de matériau à évaporer ou à sublimer dans le fond du creuset (5) d'un appareil de dépôt selon la revendication 11,
- mise sous vide par pompage de l'enceinte (1),
- chauffage du creuset contenant la charge (3) de manière à générer un flux de matière en phase vapeur par évaporation ou sublimation de la charge (3),
- filtrage par l'insert filtrant (70) de matière solide et/ou liquide tout en laissant passer le flux de matière en phase vapeur à travers l'ouverture conique (11), et
- dépôt du film de ladite matière en phase vapeur sur le substrat (10).
